# EUROPEAN PATENT APPLICATION

(11) **EP 4 800 408 A1**
(43) Date of publication of application: **02.09.2026**
(21) Application number: 25867154.4
(22) Date of filing: 07.08.2025
(51) Int. Cl.: G01R 31/392, G01R 31/378, G01R 31/367, G01R 31/382, G01R 31/396, H01M 10/052, H01M 4/52, H01M 4/50

(54) **BATTERY DIAGNOSIS APPARATUS AND BATTERY DIAGNOSIS METHOD**

(30) Priority: 14.10.2024 KR 20240139457; 14.10.2024 KR 20240139458
(71) Applicant: LG ENERGY SOLUTION, LTD., Seoul 07335 (KR)
(72) Inventor: KIM, Tae Hyeon, Daejeon 34122 (KR); KIM, Young Deok, Daejeon 34122 (KR)
(74) Representative: Goddar, Heinz J.
(86) International application number: PCT/KR2025/011892
(87) International publication number: WO 2026/084207

(57) **Abstract**

According to an embodiment disclosed in this document, there is provided a battery diagnosis device including a memory configured to store a voltage profile that represents a voltage change with respect to a capacity change of a battery cell containing an electrode based on a lithium manganese iron phosphate (LMFP) material and a nickel, cobalt, manganese (NCM) material and at least one processor, in which the at least one processor is configured to identify a first section and a second section determined based on a phase transition of the LMFP material and the NCM material in the voltage profile and identify a loss of lithium inventory (LLI) rate of the battery cell, a first capacity loss rate corresponding to the LMFP material, and a second capacity loss rate corresponding to the NCM material, based on the first section and the second section.

## Description

### TECHNICAL FIELD

### Cross-reference to Related Applications

This application claims priority from Korean Patent Application No. 10-2024-0139457, filed on October 14, 2024, the disclosure of which is incorporated by reference herein.

### Technical Field

Embodiments disclosed in this document relate to a battery diagnosis device and a battery diagnosis method.

### BACKGROUND ART

The degree of degradation of a battery cell may be composed of the sum of a loss of lithium inventory (LLI) rate and a loss of cathode active material (LAMc) rate. The degree of degradation of a positive electrode and a negative electrode of the battery cell may be quantified by identifying a change in an interval between one or more peak values in voltage data used when diagnosing the battery cell. However, when the change in the interval between one or more peak values is used, there is a problem that the LLI cannot be quantified. Therefore, there may be a need for a method capable of identifying the LLI rate of the battery cell along with a capacity loss of a material within the battery cell using the characteristics of the material.

### DISCLOSURE OF THE INVENTION

### TECHNICAL PROBLEM

Embodiments disclosed in this document provide a battery diagnosis device and a battery diagnosis method for identifying a degree of degradation of a material within a battery cell.

Embodiments disclosed in this document provide a battery diagnosis device and a battery diagnosis method for improving the accuracy of diagnosis of battery cell by quantifying an amount of loss of lithium inventory (LLI).

The technical problems of the embodiments disclosed in the document are not limited to the technical problems mentioned above, and other technical problems not mentioned will be clearly understood by those skilled in the art from the descriptions below.

### TECHNICAL SOLUTION

According to an embodiment disclosed in this document, there is provided a battery diagnosis device including a memory configured to store a voltage profile that represents a voltage change with respect to a capacity change of a battery cell containing an electrode based on a lithium manganese iron phosphate (LMFP) material and a nickel, cobalt, manganese (NCM) material and at least one processor, in which the at least one processor is configured to identify a first section and a second section determined based on a phase transition of the LMFP material and the NCM material in the voltage profile and identify a loss of lithium inventory (LLI) rate of the battery cell, a first capacity loss rate corresponding to the LMFP material, and a second capacity loss rate corresponding to the NCM material, based on the first section and the second section.

For example, the at least one processor may be configured to identify a first value and a second value corresponding to the LMFP material based on the voltage profile, identify a third value corresponding to the NCM material and included between the first value and the second value, and identify, based on the first value, a capacity area of the battery cell as the first section including the initial value of the voltage profile and the second section including the second value.

For example, the at least one processor may be configured to identify a loss of cathode active material (LAMc) rate of the battery cell using the first capacity loss rate and the second capacity loss rate.

For example, the at least one processor may be configured to identify the second capacity loss rate using the degree of degradation of the battery cell, the LLI rate of the battery cell, and the first capacity loss rate.

For example, the at least one processor may be configured to acquire a reference voltage profile representing a voltage change with respect to a capacity change of the battery cell in a BOL state, identify a first capacity change corresponding to the first section using the reference voltage profile and the voltage profile, and identify the LLI rate and a first capacity loss corresponding to the first section, based on the first capacity change.

For example, the at least one processor may be configured to identify a second capacity loss corresponding to the second section based on a second capacity change corresponding to the second section identified using the reference voltage profile and the voltage profile.

For example, the at least one processor may be configured to identify the first capacity loss rate using the first capacity loss and the second capacity loss.

For example, the at least one processor may be configured to identify the first capacity loss based on the second capacity loss and the first capacity change.

For example, the at least one processor may be configured to change an upper limit charging voltage of the battery cell based on identifying the LLI rate exceeding a designated value.

According to an embodiment disclosed in this document, there is provided a battery diagnosis method including an operation of identifying a first section and a second section determined based on a phase transition of a lithium manganese iron phosphate (LMFP) material and a nickel, cobalt, manganese (NCM) material in a voltage profile that represents a voltage change with respect to a capacity change of a battery cell containing an electrode based on the LMFP material and the NCM material, and an operation of identifying a loss of lithium inventory (LLI) rate of the battery cell, a first capacity loss rate corresponding to the LMFP material, and a second capacity loss rate corresponding to the NCM material, based on the first section and the second section.

For example, the operation of identifying the first section and the second section may include an operation of identifying a first value and a second value corresponding to the LMFP material based on the voltage profile, an operation of identifying a third value corresponding to the NCM material and included between the first value and the second value, and an operation of identifying, based on the first value, a capacity area of the battery cell as the first section including the initial value of the voltage profile and the second section including the second value).

For example, the operation of identifying the LLI rate of the battery cell, the first capacity loss rate, and the second capacity loss rate may include an operation of identifying a loss of cathode active material (LAMc) rate of the battery cell using the first capacity loss rate and the second capacity loss rate.

For example, the operation of identifying the LLI rate of the battery cell, the first capacity loss rate, and the second capacity loss rate may include an operation of identifying the second capacity loss rate using the degree of degradation of the battery cell, the LLI rate of the battery cell, and the first capacity loss rate.

For example, the operation of identifying the LLI rate of the battery cell, the first capacity loss rate, and the second capacity loss rate may include an operation of acquiring a reference voltage profile representing a voltage change with respect to a capacity change of the battery cell in a BOL state, an operation of identifying a first capacity change corresponding to the first section using the reference voltage profile and the voltage profile, and an operation of identifying the LLI rate and a first capacity loss corresponding to the first section, based on the first capacity change.

For example, the operation of identifying the LLI rate of the battery cell, the first capacity loss rate, and the second capacity loss rate may further include an operation of identifying a second capacity loss corresponding to the second section based on a second capacity change corresponding to the second section identified using the reference voltage profile and the voltage profile.

### ADVANTAGEOUS EFFECTS

The battery diagnosis device and battery diagnosis method according to the embodiments disclosed in this document can identify the degree of degradation of the material within the battery cell.

The battery diagnosis device and battery diagnosis method according to the embodiments disclosed in this document can improve the accuracy of diagnosis of battery cell by quantifying the amount of LLI.

In addition, various effects that are directly or indirectly identified through this document can be provided.

### BRIEF DESCRIPTION OF THE DRAWINGS

FIG. 1a is a block diagram showing a battery pack according to an embodiment disclosed in this document.
FIG. 1b is a block diagram illustrating the configuration of a battery diagnosis device according to an embodiment disclosed in this document.
FIG. 2 illustrates an example graph representing a voltage profile acquired by a battery diagnosis device according to an embodiment disclosed in this document.
FIG. 3 illustrates an example of a graph representing a reference voltage profile and a voltage profile acquired by a battery diagnosis device according to an embodiment disclosed in this document.
FIG. 4 illustrates an example of a table containing data related to a battery cell according to an embodiment disclosed in this document.
FIG. 5 illustrates an example of a flowchart showing operations performed by a battery diagnosis device according to an embodiment disclosed in this document.
FIG. 6 illustrates an example of a graph showing a voltage profile acquired by a battery diagnosis device according to an embodiment disclosed in this document.
FIG. 7 illustrates an example of a graph representing a reference voltage profile and a voltage profile acquired by a battery diagnosis device according to an embodiment disclosed in this document.
FIG. 8 illustrates an example of a table containing data related to a battery cell according to an embodiment disclosed in this document.
FIG. 9 illustrates an example of a flowchart showing operations performed by a battery diagnosis device according to an embodiment disclosed in this document.
FIG. 10 illustrates a computing system executing a battery diagnosis method according to an embodiment disclosed in this document.

### MODE FOR CARRYING OUT THE INVENTION

Hereinafter, some embodiments described in this document are described with reference to the accompanying drawings. However, this is not intended to limit the present technology to a specific embodiment, but should be understood to include various modifications, equivalents, and/or alternatives of the embodiments of the present technology.

When adding reference numerals to components in each drawing, it should be noted that the same components are given the same reference numerals as much as possible even if they are shown in different drawings. In addition, when describing various embodiments disclosed in this document, if a specific description of a related known configuration or function is determined to hinder understanding of the embodiments of the present disclosure, the detailed description thereof is omitted. A singular form of a noun corresponding to an item may include one item or a plurality of items unless the relevant context clearly indicates otherwise.

In describing the components of the embodiments of this document, terms such as first, second, A, B, (a), (b), etc. may be used. These terms are only intended to distinguish the components from other components, and the nature, order, or sequence of the components are not limited by the terms. In addition, unless otherwise defined, all terms used herein, including technical or scientific terms, have the same meaning as generally understood by a person having ordinary skill in the art to which the embodiments disclosed in this document belong. Terms defined in commonly used dictionaries should be interpreted as having a meaning consistent with the meaning they have in the context of the relevant technology, and shall not be interpreted in an ideal or excessively formal sense unless explicitly defined in this application.

In addition, in the present disclosure, expressions of "more than" or "less than" may be used to determine whether a specific condition is satisfied or fulfilled, but this is only a description for expressing an example and does not exclude descriptions of "greater than or equal to" or "less than or equal to". A condition described as "greater than or equal to" may be replaced with "more than", a condition described as "less than or equal to" may be replaced with "less than", and a condition described as "greater than or equal to and less than" may be replaced with "more than and less than or equal to". In addition, hereinafter, "A" to "B" mean at least one of the elements from A (including A) to B (including B).

In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

The method according to the various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or distributed through an application store, distributed directly between two user devices, or distributed online (e.g., downloaded or uploaded). In the case of online distribution, at least a part of the computer program product may be temporarily stored or temporarily generated in a machine-readable recording medium, such as a memory of a manufacturer's server, an application store's server, or a relay server.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by adding one or more other operations.

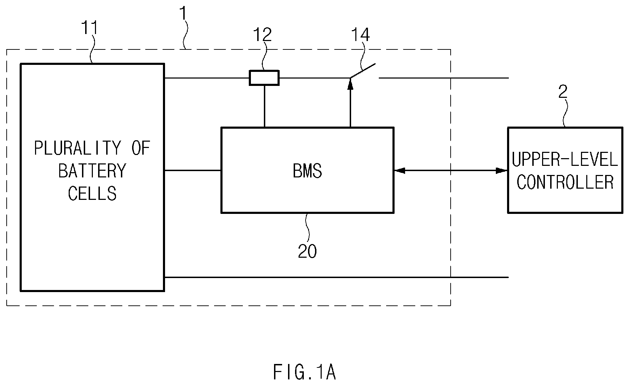

FIG. 1a is a block diagram showing a battery pack according to an embodiment disclosed in this document.

Referring to FIG. 1a, a battery control system including a battery pack 1 and an upper-level controller 2 included in an upper-level system according to an embodiment disclosed in this document is schematically illustrated.

As illustrated in FIG. 1a, the battery pack 1 may include a plurality of battery cells 11 (or one or more battery cells), a switching unit 14 connected in series to a first terminal side and/or a second terminal side of the plurality of battery cells 11 to control a charge and/or discharge current flow of the plurality of battery cells 11, and a battery management system 20 that monitors the voltage, current, temperature, etc. of the battery pack 1 to prevent overcharging and overdischarging.

In this case, the battery pack 1 may be equipped with a plurality of the plurality of cells 11, sensors 12, switching units 14, and battery management systems 20. For example, a first terminal may be a positive (+) terminal of the plurality of battery cells 11, and a second terminal may be a negative (-) terminal thereof.

Here, the switching unit 14 is a device for controlling the current flow for charging or discharging the plurality of battery cells 11, and for example, at least one relay, magnetic contactor, etc. may be used depending on the specifications of the battery pack 1.

For example, the plurality of battery cells 11 may include a cylindrical battery. The cylindrical battery may refer to a battery in which battery materials are packaged in a cylindrical shape.

The battery management system 20 is an interface that receives values obtained by measuring various parameters described above, and may include a plurality of terminals, a circuit connected to these terminals and performs processing of the received values, etc. In addition, the battery management system 20 may control the ON/OFF of the switching unit 14, for example, a relay or a contactor, and may be connected to the battery cell 11 to monitor the state of each of the plurality of battery cells 11.

The upper-level controller 2 may transmit a control signal for the plurality of battery cells 11 to the battery management system 20. Accordingly, the operation of the battery management system 20 may be controlled based on a signal applied from the upper-level controller 2.

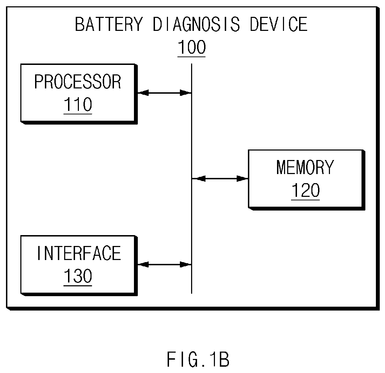

According to the embodiment, the battery management system 20 may include a battery diagnosis device 100 of FIG. 1b. According to another embodiment, the battery management system 20 may be another system different from the battery diagnosis device 100 of FIG. 1b. That is, the battery diagnosis device 100 of FIG. 1b may be included in the battery pack 1 or may be configured as another device external to the battery pack 1. For convenience of description, it will be described on the premise that the battery diagnosis device 100 is configured as another device external to the battery pack 1.

FIG. 1b is a block diagram illustrating the configuration of a battery diagnosis device according to an embodiment disclosed in this document.

The battery diagnosis device 100 according to an embodiment may include at least one of a processor 110, a memory 120, and an interface 130. The processor 110, the memory 220, and the interface 130 may be electronically and/or operably coupled with each other by an electronic component including a communication bus. Hereinafter, operably coupling pieces of hardware with each other may mean a direct connection and/or an indirect connection between pieces of hardware being established in a wired manner and/or wirelessly, such that a second piece of hardware is controlled by a first piece of hardware among the pieces of hardware. Although pieces of hardware are illustrated in different blocks, embodiments are not limited thereto. Some of the pieces of hardware of FIG. 1b (e.g., at least a portion of the processor 110, memory 120, and communication circuit (not shown)) may be included in a single integrated circuit, such as a system on a chip (SoC). Communication methods between components may include buses, general purpose input and output (GPIO), serial peripheral interface (SPI), mobile industry processor interface (MIPI), etc.

The processor 110 of the battery diagnosis device 100 according to an embodiment may include a hardware component for processing data based on one or more instructions. Hardware components for processing data may include, for example, an arithmetic and logic unit (ALU), a floating point unit (FPU), a field programmable gate array (FPGA), a central processing unit (CPU), a micro controller unit (MCU), and/or an application processor (AP). The number of processors 110 may be one or more. For example, the processor 110 may have a multi-core processor architecture having dual cores, quad cores, hexa cores, or octa cores.

The memory 120 of the battery diagnosis device 100 according to an embodiment may include hardware components for storing data and/or instructions input and/or output to and from the processor 110. The memory 120 may include, for example, a volatile memory such as a random-access memory (RAM) and/or a non-volatile memory such as a read-only memory (ROM). For example, the volatile memory may include at least one of dynamic RAM (DRAM), static RAM (SRAM), cache RAM, and pseudo SRAM (PSRAM). For example, the non-volatile memory may include at least one of programmable ROM (PROM), erasable PROM (EPROM), electrically erasable PROM (EEPROM), flash memory, a hard disk, a compact disc, a solid state drive (SSD), and an embedded multi-media card (eMMC). For example, the memory 120 may be configured to store a voltage profile representing a voltage change with respect to a capacity change of a battery cell containing a lithium manganese iron phosphate (LMFP) material and/or a nickel, cobalt, manganese (NCM) material. For example, the LMFP material and/or the NCM material may be contained in the electrode of the battery cell.

The interface 130 of the battery diagnosis device 100 according to an embodiment may be configured to generate various battery measurement values from the battery. To this end, the interface 130 may include measuring means such as a voltmeter, ammeter, thermometer, etc., and a communication circuit for establishing a communication link with an external device. As an example, the interface 130 may include a temperature sensor attached to the battery cell.

For example, the interface 130 may be configured to acquire a temperature profile representing a relationship between the voltage of the battery cell and the temperature of the battery cell. The interface 130 may be configured to acquire a voltage profile representing a relationship between the voltage of the battery cell and the capacity of the battery cell. For example, the voltage profile may represent a voltage change with respect to a capacity change of a battery cell including an electrode based on the lithium manganese iron phosphate (LMFP) material and/or the nickel, cobalt, manganese (NCM) material. According to various embodiments, the electrode based on the LMFP material and/or the NCM material may include an electrode formed entirely or partially using the LMFP material and/or the NCM material.

The battery diagnosis device 100 according to an embodiment may identify a first section and a second section determined based on a phase transition of the LMFP material in the voltage profile. For example, the battery diagnosis device 100 may identify a loss of lithium inventory (LLI) rate of the battery cell based on the first section and the second section.

The battery diagnosis device 100 according to an embodiment may identify a first value indicating the phase transition of the LMFP material based on the voltage profile related to the battery cell including the electrode based on the LMFP material. For example, the first value may be identified when all iron (Fe) ions contained in the LMFP material react.

The battery diagnosis device 100 according to an embodiment may divide a capacity area of the battery cell into the first section and the second section based on the first value. For example, the first section may include an initial value. For example, the second section may include a second value that is distinct from the first value. For example, the second value may be identified when all manganese (Mn) ions contained in the LMFP material react.

For example, the first section may include a section from an initial value to the first value. The second section may include a section from the first value to a last value in the capacity area. As an example, the second section may include a section from the first value to a second value.

The battery diagnosis device 100 according to an embodiment may identify a loss of lithium inventory (LLI) rate and a loss of cathode active material (LAMc) rate of the battery cell based on the first section and the second section.

The battery diagnosis device 100 according to an embodiment may acquire a reference voltage profile representing the voltage change with respect the capacity change of the battery cell in a beginning of life (BOL) state. For example, the battery diagnosis device 100 may identify a first capacity change corresponding to the first section using the reference voltage profile and the voltage profile. For example, the battery diagnosis device 100 may identify the LLI rate and a first capacity loss corresponding to the first section based on the first capacity change.

The battery diagnosis device 100 according to an embodiment may identify a second capacity loss corresponding to the second section based on a second capacity change corresponding to the second section identified using the reference voltage profile and the voltage profile.

The battery diagnosis device 100 according to an embodiment may identify the first capacity loss based on the second capacity loss and the first capacity change. For example, the battery diagnosis device 100 may identify the first capacity loss based on multiplying a capacity loss rate corresponding to the second capacity loss by the first capacity change.

For example, the battery diagnosis device 100 may identify a capacity corresponding to the second section using the reference capacity profile. The battery diagnosis device 100 may identify the second capacity loss with respect to the capacity corresponding to the second section as the capacity loss rate.

In an embodiment, the battery diagnosis device 100 may identify the LAMc rate using the first capacity loss and the second capacity loss. For example, the battery diagnosis device 100 may identify the sum of the first capacity loss and the second capacity loss as the LAMc rate.

The battery diagnosis device 100 according to an embodiment may identify the LLI using the first capacity change and the first capacity loss. For example, the battery diagnosis device 100 may identify a difference between the first capacity change and the first capacity loss as the LLI.

In an embodiment, the battery diagnosis device 100 may identify a reference capacity of the battery cell from the reference voltage profile. For example, the reference capacity of the battery cell may mean the total capacity of the battery cell in the BOL state.

In an embodiment, the battery diagnosis device 100 may identify the LLI rate indicating a ratio of LLI to the reference capacity of the battery cell.

The battery diagnosis device 100 according to an embodiment may identify a degree of degradation of the battery cell using the LLI rate and the LAMc rate.

The battery diagnosis device 100 according to an embodiment may identify the voltage profile representing the voltage change with respect to the capacity change of the battery cell containing the lithium manganese iron phosphate (LMFP) material and the nickel, cobalt, manganese (NCM) material. For example, the battery cell containing the LMFP material and the NCM material may include an electrode based on the LMFP material and the NCM material.

The battery diagnosis device 100 according to an embodiment may identify the first section and the second section determined based on the phase transition of the LMFP material and the NCM material in the voltage profile. For example, the battery diagnosis device 100 may identify the LLI rate of the battery cell, a first capacity loss rate corresponding to the LMFP, and a second capacity loss rate corresponding to the NCM based on the first section and the second section.

The battery diagnosis device 100 according to an embodiment may identify the first value and the second value corresponding to the LMFP material based on the voltage profile. For example, the battery diagnosis device 100 may identify a third value corresponding to the NCM material. The third value may be included between the first value and the second value. The third value may be identified when all of the at least one ion (e.g., nickel ion) contained in the NCM material reacts.

The battery diagnosis device 100 according to an embodiment may divide the capacity area of the battery cell into the first section including the initial value of the voltage profile and the second section including the second value based on the first value.

The battery diagnosis device 100 according to an embodiment may identify the LAMc rate of the battery cell using the first capacity loss rate and the second capacity loss rate. The battery diagnosis device 100 may identify the sum of the first capacity loss rate and the second capacity loss rate as the LAMc rate.

The battery diagnosis device 100 according to an embodiment may identify the second capacity loss rate using the degree of degradation of the battery cell, the LLI rate of the battery cell, and the first capacity loss rate. For example, the battery diagnosis device 100 may identify a difference between the degree of degradation of the battery cell and the sum of the LLI rate and the first capacity loss rate as the second capacity loss rate.

The battery diagnosis device 100 according to an embodiment may acquire the reference voltage profile representing the voltage change with respect to the capacity change of the battery cell in the beginning of life (BOL) state.

For example, the battery diagnosis device 100 may identify the first capacity change corresponding to the first section using the reference voltage profile and the voltage profile. For example, the battery diagnosis device 100 may identify the LLI rate and the first capacity loss corresponding to the first section based on the first capacity change.

For example, the battery diagnosis device 100 may identify the second capacity loss corresponding to the second section based on the second capacity change corresponding to the second section identified using the reference voltage profile and the voltage profile.

For example, the battery diagnosis device 100 may identify the first capacity loss based on the second capacity loss and the first capacity change. For example, the battery diagnosis device 100 may identify the first capacity loss based on multiplying the capacity loss rate corresponding to the second capacity loss by the first capacity change.

For example, the battery diagnosis device 100 may identify the first capacity loss rate corresponding to the LMFP material using the first capacity loss and the second capacity loss. The battery diagnosis device 100 may identify the first capacity loss rate based on the sum of the first capacity loss and the second capacity loss.

For example, the battery diagnosis device 100 may identify the reference capacity of the battery cell in the BOL state in the reference capacity profile. The battery diagnosis device 100 may identify a ratio of the reference capacity and the sum of the first capacity loss and the second capacity loss as the first capacity loss rate.

For example, the battery diagnosis device 100 may identify the difference between the first capacity change and the first capacity loss as the LLI.

For example, the battery diagnosis device 100 may identify the LLI rate, which represents the ratio of the LLI to the reference capacity of the battery cell.

The battery diagnosis device 100 according to an embodiment may change an upper limit charging voltage of the battery cell based on identifying the LLI rate exceeding a designated value. The upper limit charging voltage may indicate the maximum available voltage of the battery cell. The battery diagnosis device 100 may temporarily stop charging the battery cell by identifying the upper limit charging voltage while the battery cell is charged.

The battery diagnosis device 100 according to an embodiment may adjust the charging speed of the battery cell based on identifying the LLI rate exceeding the designated value. For example, the battery diagnosis device 100 may lower the charging speed of the battery cell.

The battery diagnosis device 100 according to an embodiment as described above may acquire the LLI rate by identifying the capacity loss of each of the electrode materials contained in the battery cell. The battery diagnosis device 100 may control the battery cell based on acquiring the LLI rate. The battery diagnosis device 100 may adjust (or lower) the rate at which the battery cell is degraded based on controlling the battery cell.

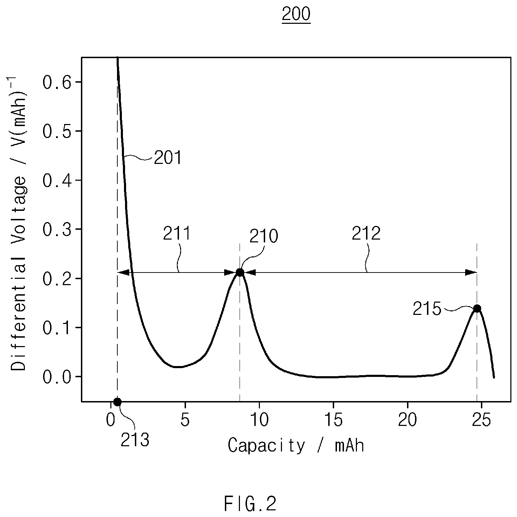

FIG. 2 illustrates an example graph representing a voltage profile acquired by a battery diagnosis device according to an embodiment disclosed in this document. The battery diagnosis device 100 of FIG. 2 may be referenced to the battery diagnosis device 100 of FIG. 1b. The battery diagnosis device 100 according to an embodiment may acquire data on the battery cell including an electrode based on the LMFP material.

Referring to FIG. 2, a graph 200 may include a voltage profile 201 representing a voltage change with respect to a capacity change of a battery cell.

The battery diagnosis device 100 according to an embodiment may identify a first section 211 and a second section 212 determined based on a phase transition of the LMFP material in the voltage profile 201.

In an embodiment, the battery diagnosis device 100 may identify a first value 210 representing the phase transition of the LMFP material based on the voltage profile. The first value 210 may be identified when lithium ions have completely escaped from an area corresponding to iron (Fe) contained in the LMFP material to another area.

In an embodiment, the battery diagnosis device 100 may divide the capacity area of the battery cell into a first section 211 including an initial value 213 of the voltage profile and a second section 212 thereof based on the first value 210. For example, the second section 212 may include a second value 215 that is distinct from the first value 210. The second value 215 may indicate a case where all manganese (Mn) ions contained in the LMFP material react.

In an embodiment, the battery diagnosis device 100 may identify the LLI rate and the LAMc rate of the battery cell based on the first section 211 and the second section 212.

The battery diagnosis device 100 according to an embodiment as described above may distinguish a section for identifying the LLI rate and the LAMc rate by identifying the first value 210 representing the phase transition of the LMFP material in the voltage profile. The battery diagnosis device 100 may quantify the degree of degradation of the LMFP material according to the distinct sections.

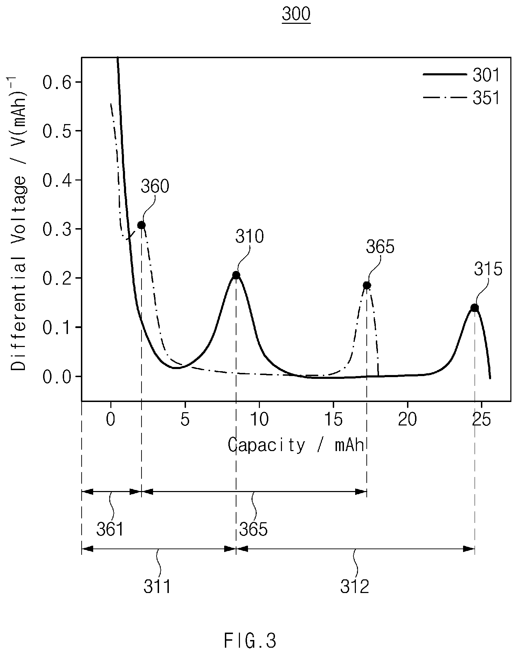

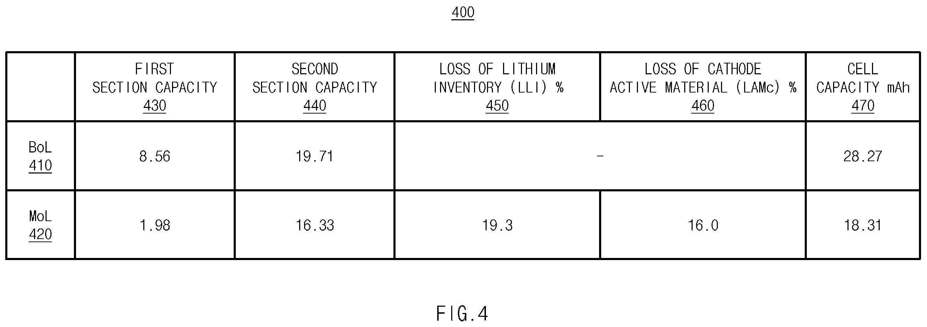

FIG. 3 illustrates an example of a graph representing a reference voltage profile and a voltage profile acquired by a battery diagnosis device according to an embodiment disclosed in this document. FIG. 4 illustrates an example of a table containing data related to a battery cell according to an embodiment disclosed in this document. The battery diagnosis device 100 of FIGS. 3 and 4 may include the battery diagnosis device 100 of FIG. 1b. The battery diagnosis device 100 of FIGS. 3 and 4 may acquire data on the battery cell including an electrode based on the LMFP material.

Referring to FIG. 3, a graph 300 may include a reference voltage profile 301 representing a voltage change with respect to a capacity change of a battery cell in a BOL state, and a voltage profile 351 representing a voltage change with respect to a capacity change of a battery cell in a current state (e.g., a middle of life (MOL) state).

The battery diagnosis device 100 according to an embodiment may identify a first capacity change corresponding to the first section (e.g., the first section 211 of FIG. 2) using the reference voltage profile 301 and the voltage profile 351.

For example, the battery diagnosis device 100 may identify a first reference section 311 and a second reference section 312 using a first reference value 310 of the reference voltage profile 301. The second reference section 312 may include a second reference value 315. For example, the second reference section 312 may include a last value of the reference voltage profile 301 from the first reference value 310.

For example, the battery diagnosis device 100 may identify a first section 361 and a second section 362 using a first value 360 of the voltage profile 351. The second section 362 may include a second value 365.

Referring to FIG. 4, a table 400 may include the reference voltage profile 301 and one or more values indicating data included in the voltage profile 351.

For example, the table 400 may include reference capacity data 410 related to a battery cell in a BOL state and capacity data 420 related to a battery cell in a MOL state. The reference capacity data 410 related to the battery cell in the BOL state may be referenced to the reference voltage profile 301. The capacity data 420 related to the battery cell in the MOL state may be referenced to the voltage profile 351.

In an embodiment, the battery diagnosis device 100 may identify a first section capacity value 430 corresponding to the first section 361 (or the first reference section 311). The battery diagnosis device 100 may identify a second section capacity value 440 corresponding to the second section 362 (or the second reference section 312).

The battery diagnosis device 100 according to an embodiment may identify an LLI rate and a first capacity loss corresponding to the first section 361 based on the first capacity change.

For example, the battery diagnosis device 100 may identify a first reference capacity value (e.g., 8.56 mAh) corresponding to the first reference section 311 using the reference capacity data 410. The first reference capacity value may indicate a difference between the first reference value 310 and the initial value of the reference voltage profile 301.

For example, the battery diagnosis device 100 may identify a first capacity value (1.98 mAh) corresponding to the first section 361 using the capacity data 420. The first capacity value may indicate a difference between the first value 360 and the initial value of the voltage profile 351.

The battery diagnosis device 100 according to an embodiment may identify a second capacity loss corresponding to the second section 362 based on the second capacity change corresponding to the second section 362 identified using the reference voltage profile 301 and the voltage profile 351.

For example, the battery diagnosis device 100 may identify a second reference capacity value (e.g., 19.71 mAh) corresponding to the second reference section 312 using the reference capacity data 410. The second reference capacity value may indicate a difference between the first reference value 310 and the last value (or the second reference value 315) of the reference voltage profile 301.

For example, the battery diagnosis device 100 may identify a second capacity value (e.g., 16.33 mAh) corresponding to the second section 362 using the capacity data 420. The second capacity value may indicate a difference between the first value 360 and the last value (or the second value 365) of the voltage profile 351.

For example, the battery diagnosis device 100 may identify (or set) a difference between the second reference capacity value and the second capacity value as the second capacity loss corresponding to the second section 362. That is, when the LAMc occurs, shrinkage of the voltage profile occurs, and thus the battery diagnosis device 100 may identify the second capacity loss (e.g., 3.38 mAh) corresponding to the second section 362 using the difference between the second reference capacity value and the second capacity value. The difference between the second reference capacity value and the second capacity value may be referred to as a second capacity change.

The battery diagnosis device 100 according to an embodiment may identify the first capacity loss based on the second capacity loss and the first capacity change.

For example, the battery diagnosis device 100 may identify the second capacity loss rate (e.g., approximately 17.14%) using a ratio (e.g., percentage) of the second capacity loss and the second section capacity value 440 (e.g., 19.71 mAh) of the reference capacity data 410.

For example, the battery diagnosis device 100 may identify (or set) the difference between the first reference capacity value (e.g., 8.56 mAh) of the reference capacity data 410 and the first capacity value (e.g., 1.98 mAh) of the capacity data 420 as the first capacity change (e.g., 6.58 mAh) corresponding to the first section 361.

For example, the battery diagnosis device 100 may identify the first capacity loss (e.g., 1.128 mAh) by multiplying the first capacity change by the second capacity loss.

The battery diagnosis device 100 according to an embodiment may identify the LLI using the first capacity change and the first capacity loss.

For example, the battery diagnosis device 100 may identify the difference between the first capacity change (e.g., 6.58 mAh) and the first capacity loss (e.g., 1.128 mAh) as the LLI (e.g., 5.452 mAh).

For example, since the LLI occurs in the first section 361 of the first section 361 and the second section 362, the battery diagnosis device 100 may identify the LLI corresponding to the first section 361 as the LLI of the entire battery cell.

In an embodiment, the battery diagnosis device 100 may identify the reference capacity (e.g., 28.27 mAh) of the battery cell from the reference voltage profile. The reference capacity may represent the total capacity of the battery cell in the BOL state.

For example, the battery diagnosis device 100 may identify the reference capacity (e.g., 28.27 mAh) of the battery cell in the BOL state from the cell capacity value 470 of the reference capacity data 410.

In an embodiment, the battery diagnosis device 100 may identify an LLI rate (e.g., approximately 19.28%), which represents the ratio of the LLI to the reference capacity of the battery cell.

In an embodiment, the battery diagnosis device 100 may identify a LAMc rate using the first capacity loss and the second capacity loss.

For example, the battery diagnosis device 100 may identify the LAMc rate using the sum of the first capacity loss (e.g., 1.128 mAh) and the second capacity loss (e.g., 3.38 mAh).

For example, the battery diagnosis device 100 may identify the LAMc rate (e.g., approximately 15.96%) using the sum of the first capacity loss and the second capacity loss for the cell capacity value 470 (e.g., 28.27 mAh) of the reference capacity data 410.

The battery diagnosis device 100 according to an embodiment may identify the first capacity loss and the LLI using the first section 361 (and the first reference section 311). The battery diagnosis device 100 may identify the second capacity loss using the second section 362 (and the second reference section 312).

In an embodiment, the battery diagnosis device 100 may identify the degree of degradation of the battery cell using the LLI rate and the LAMc rate. For example, the battery diagnosis device 100 may identify the sum of the LLI rate and the LAMc rate as the degree of degradation of the battery cell (e.g., approximately 35.3%). However, it is not limited thereto. For example, the battery diagnosis device 100 may acquire the degree of degradation of the battery cell using other data that is distinct from the voltage profile 351.

In an embodiment, the battery diagnosis device 100 may calculate the degree of degradation of the battery cell using the cell capacity value 470. For example, the battery diagnosis device diagnosis device 100 may calculate the degree of degradation of the battery cell using a first reference capacity (e.g., 28.27 mAh) indicating the cell capacity value 470 of the reference capacity data 410 and a second reference capacity (e.g., 18.31 mAh) indicating the cell capacity value 470 of the capacity data 420.

The battery diagnosis device 100 according to an embodiment may change the upper limit charging voltage of the battery cell when an LLI rate exceeding a designated value is identified. For example, the upper limit charging voltage may represent a maximum voltage of the voltage of a battery cell that can be charged. For example, when the battery diagnosis device 100 identifies the LLI rate that exceeds the designated value, the battery diagnosis device 100 may adjust the charging speed for charging the battery cell.

The battery diagnosis device 100 according to an embodiment as described above may identify at least one peak value (e.g., the first value 360) indicating the phase transition of the LMFP material using the voltage profile. The battery battery diagnosis device 100 may divide the voltage profile into the first section 361 and the second section 362 using at least one peak value. The battery diagnosis device 100 may identify the first capacity loss corresponding to the first section and the LLI for the entire battery cell using the first section 361. The battery diagnosis device 100 may identify the second capacity loss corresponding to the second section using the second section 362. The battery diagnosis device 100 may quantify the LLI of the battery cell based on at least one peak value. The battery diagnosis device 100 may improve the accuracy of diagnosis of the battery cell by quantifying the LLI.

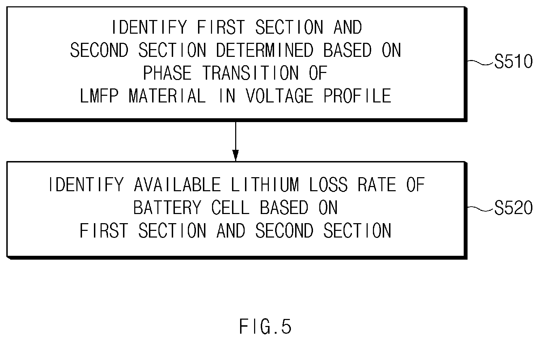

FIG. 5 illustrates an example of a flowchart showing operations performed by a battery diagnosis device according to an embodiment disclosed in this document. In the following, it is assumed that the battery diagnosis device 100 of FIG. 1b performs the process of FIG. 5. In addition, the operations described as being performed by the device may be understood to be controlled by the processor 110 of the battery diagnosis device 100. Each of the operations in FIG. 5 may be performed sequentially, but they are not necessarily performed sequentially. For example, the order of each of the operations may be changed, and at least two operations may be performed in parallel. In addition, the operation of the battery diagnosis device 100 may be performed by a battery management system (BMS) in the vehicle, as well as by various devices such as a server, cloud, charger, or charger/discharger.

In operation S510, the battery diagnosis device according to an embodiment may identify a first section and a second section determined based on a phase transition of an LMFP material in a voltage profile.

For example, the battery diagnosis device may identify a first value representing the phase transition of the LMFP material based on the voltage profile.

For example, the battery diagnosis device may divide a capacity area of a battery cell into a first area including an initial value and a second area different from the first area based on the first value.

In operation S520, the battery diagnosis device according to an embodiment may identify an LLI rate of the battery cell based on the first section and the second section.

For example, the battery diagnosis device may identify the LLI rate and the LAMc rate of the battery cell based on the first section and the second section.

For example, the battery diagnosis device may identify the LLI rate and the LAMc rate of the battery cell using a reference voltage profile acquired from a battery cell in a BOL state and a voltage profile acquired from the battery cell in a MOL state.

For example, the battery diagnosis device may identify the LLI rate and a first capacity loss indicating the LAMc corresponding to the first section using the first section. For example, the battery diagnosis device may identify a second capacity loss indicating the LAMc corresponding to the second section using the second section.

For example, the battery diagnosis device may identify the LAMc rate for the entire battery cell using the sum of the first capacity loss and the second capacity loss.

For example, the battery diagnosis device may diagnose the degree of degradation of the battery cell using the LLI rate and the LAMc rate of the battery cell.

For example, the battery diagnosis device may lower an upper limit charging voltage of the battery cell when the LLI rate of the battery cell exceeds a designated value.

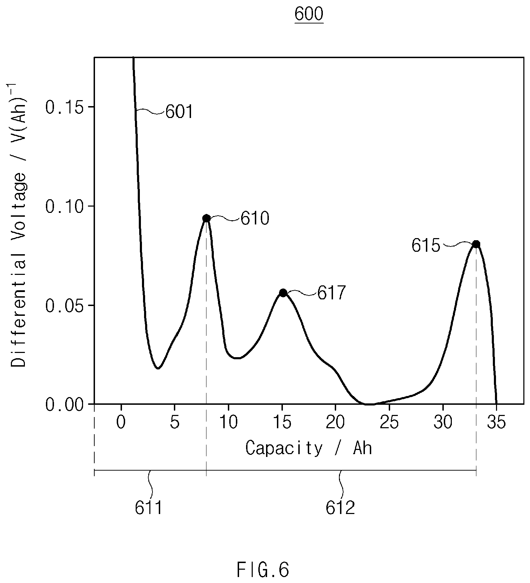

FIG. 6 illustrates an example of a graph showing a voltage profile acquired by a battery diagnosis device according to an embodiment disclosed in this document. The battery diagnosis device 100 of FIG. 6 may be referenced to the battery diagnosis device 100 of FIG. 1b. The battery cell included in the battery diagnosis device 100 of FIG. 6 may contain an LMFP material and an NCM material. That is, the battery diagnosis device 100 may include a battery cell including an electrode (e.g., a positive electrode) based on the LMFP material and the NCM material.

Referring to FIG. 6, a graph 600 may include a voltage profile 601 representing a voltage change with respect to a capacity change of the battery cell.

The battery diagnosis device 100 according to an embodiment may identify a first section 611 and a second section 612 determined based on the phase transition of the LMFP material and the NCM material in the voltage profile 601.

In an embodiment, the battery diagnosis device 100 may identify a first value 610 representing the phase transition of the LMFP material based on the voltage profile. The first value 610 may indicate a case where all iron (Fe) ions contained in the LMFP material react.

In an embodiment, the battery diagnosis device 100 may divide a capacity area of the battery cell into the first section 611 and the second section 612 including an initial value of the voltage profile based on the first value 610. For example, the second section 612 may include a second value 615 distinguished from the first value 610. The second value 615 may indicate that the lithium ions escape to another area in an area corresponding to manganese (Mn) contained in the LMFP material. As an example, the second section 612 may include a section between the first value 610 and the last value of the voltage profile 601.

The battery diagnosis device 100 according to an embodiment may identify the first value 610 and the second value 615 corresponding to the LMFP material based on the voltage profile 601.

For example, the battery diagnosis device 100 corresponds to an NCM material and may identify a third value 617 included between the first value 610 and the second value 615.

The battery diagnosis device 100 according to an embodiment may identify an LLI rate of the battery cell, a first capacity loss rate corresponding to LMFP, and a second capacity loss rate corresponding to NCM based on the first section 611 and the second section 612. For example, when the third value 617 is included between the first value 610 and the second value 615, the battery diagnosis device 100 may identify the LLI rate of the battery cell, the first capacity loss rate corresponding to the LMFP, and the second capacity loss rate corresponding to the NCM using the first section 611 and the second section 612.

As the content of nickel included in the NCM material increases relatively, the battery diagnosis device 100 according to an embodiment may identify more peak values corresponding to the NCM material and different from the third value 617 in the voltage profile 601. The identified peak value may not be included between the initial value and the second value 615 of the voltage profile 601. That is, the identified peak value may be identified at a capacity greater than the identified capacity of the second value 615 (e.g., a capacity included within a range between the second value 615 and the last value of the voltage profile 601).

The battery diagnosis device 100 according to an embodiment as described above may distinguish a section for identifying the LLI rate and the LAMc rate by identifying at least one peak value representing the phase transition of the LMFP material and the NCM material in the voltage profile. The battery diagnosis device 100 may quantify the degree of degradation of each of the LMFP material and the NCM material according to the distinct sections.

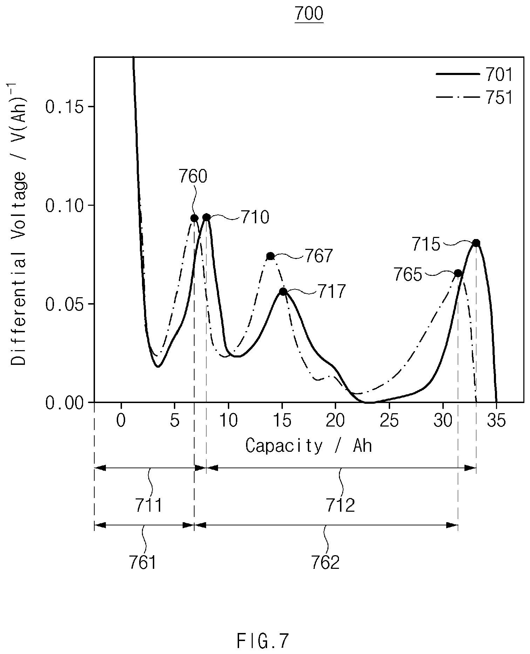

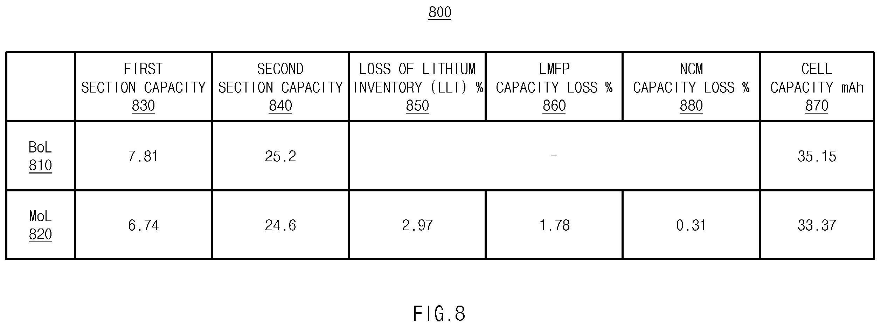

FIG. 7 illustrates an example of a graph representing a reference voltage profile and a voltage profile acquired by a battery diagnosis device according to an embodiment disclosed in this document. FIG. 8 illustrates an example of a table containing data related to a battery cell according to an embodiment disclosed in this document. The battery diagnosis device 100 of FIGS. 7 and 8 may be referenced to the battery diagnosis device 100 of FIG. 1b. The battery cell included in the battery diagnosis device of FIGS. 7 and 8 may contain the LMFP material and the NCM material. That is, the battery diagnosis device 100 may include a battery cell including an electrode (e.g., a positive electrode) based on the LMFP material and the NCM material.

Referring to FIG. 7, a graph 700 may include a reference voltage profile 701 indicating a voltage change with respect to a capacity change of a battery cell in a BOL state, and a voltage profile 751 indicating the voltage change with respect to a capacity change of the battery cell in a current state (e.g., a middle of life (MOL) state).

The battery diagnosis device 100 according to an embodiment may identify a first capacity change corresponding to a first section (e.g., the first section 611 of FIG. 6) using the reference voltage profile 701 and the voltage profile 751.

For example, the the battery diagnosis device 100 may identify a first reference section 711 and a second reference section 712 using a first reference value 710 of the reference voltage profile 701. A second reference interval 712 may include a second reference value 715. For example, the second reference interval 712 may include the last value of the reference voltage profile 701 from the first reference value 710. The first reference value 710 and the second reference value 715 may indicate the phase transition of the LMFP material contained in the battery cell in the BOL state.

For example, the battery diagnosis device 100 may identify a first section 761 and a second section 762 using the first value 760 of the voltage profile 751. The second section 762 may include a second value 765 or the last value of the voltage profile 751. The first value 760 and the second value 765 may indicate the phase transition of the LMFP material contained in the battery cell in the current state.

The battery diagnosis device 100 according to an embodiment may identify a third reference value 717 indicating the phase transition of an NCM material in the reference voltage profile 701. The third reference value 717 may be included between the first reference value 710 and the second reference value 715.

The battery diagnosis device 100 according to an embodiment may identify a third value 767 representing the phase transition of the NCM material in the voltage profile 751. The third value 767 may be included between the first value 760 and the second value 765.

When the third value 767 is included between the first value 760 and the second value 765, the battery diagnosis device 100 according to an embodiment may quantify the degree of deterioration of each of the NCM material and the LMFP material.

Referring to FIG. 8, a table 800 may include one or more values indicating data included in the reference voltage profile 701 and the voltage profile 751.

For example, table 800 may include reference capacity data 810 related to a battery cell in a BOL state and capacity data 820 related to a battery cell in a MOL state. The reference capacity data 810 related to the battery cell in the BOL state may be referenced to the reference voltage profile 301. The capacity data 420 related to the battery cell in the MOL state may be referenced to the voltage profile 351.

For example, each of the reference capacity data 810 and/or the capacity data 420 may include data representing a first section capacity value 830, a second section capacity value 840, an LLI rate 850, an LMFP capacity loss rate 860, an NCM capacity loss rate 880, and/or a cell capacity value 870 indicating a reference capacity of the battery cell.

In an embodiment, the battery diagnosis device 100 may identify the first section capacity value 830 corresponding to the first section 761 (or the first reference section 711). The battery diagnosis device 100 may identify a second section capacity value 740 corresponding to the second section 762 (or the second reference section 712).

The battery diagnosis device 100 according to an embodiment may identify the LLI rate and a first capacity loss corresponding to the first section 761 based on a first capacity change.

For example, the battery diagnosis device 100 according to an embodiment may identify a first reference capacity value (e.g., 7.81 mAh) corresponding to the first reference section 711 using the reference capacity data 810. The first reference capacity value may indicate a difference between the first reference value 710 and the initial value of the reference voltage profile 701.

For example, the battery diagnosis device 100 may identify a first capacity value (e.g., 6.74 mAh) corresponding to the first section 761 using the capacity data 820. The first capacity value may indicate a difference between the first value 760 and the initial value of the voltage profile 751.

The battery diagnosis device 100 according to an embodiment may identify a second capacity loss corresponding to the second section 762 based on a second capacity change corresponding to the second section 762 identified using the reference voltage profile 701 and the voltage profile 751.

For example, the battery diagnosis device 100 may identify a second reference capacity value (e.g., 25.2 mAh) corresponding to the second reference section 712 using the reference capacity data 810. The second reference capacity value may represent a difference between the first reference value 710 and the second reference value 315 of the reference voltage profile 701 (or the last value of the reference voltage profile 701).

For example, the battery diagnosis device 100 may identify a second capacity value (e.g., 24.6 mAh) corresponding to the second section 762 using the capacity data 820. The second capacity value may represent a difference between the first value 760 and the second value 765 (or last value) of the voltage profile 751.

For example, the battery diagnosis device 100 may identify (or set) a difference between the second reference capacity value and the second capacity value as the second capacity loss corresponding to the second section 762.

That is, when a LAMc occurs, since shrinkage of the voltage profile occurs, the battery diagnosis device 100 may identify the second capacity loss (e.g., 0.6 mAh) corresponding to the second section 762 using a difference between the second reference capacity value (e.g., 25.2 mAh) and the second capacity value (e.g., 24.6 mAh). A difference between the second reference capacity value and the second capacity value may be referred to as a second capacity change.

The battery diagnosis device 100 according to an embodiment may identify the first capacity loss based on the second capacity loss and the first capacity change. The first capacity loss may represent a portion of the capacity loss of the LMFP material.

For example, the battery diagnosis device 100 may identify a second capacity loss rate (e.g., approximately 2.38%) using a ratio (e.g., percentage) of the second capacity loss (e.g., 0.6 Ah) and the second section capacity value 840 (e.g., 25.2 Ah) of the reference capacity data 810.

For example, the battery diagnosis device 100 may identify (or set) the difference between the first reference capacity value (e.g., 7.81 Ah) of the reference capacity data 810 and the first capacity value (e.g., 6.74 Ah) of the capacity data 820 as the first capacity change (e.g., 1.07 Ah) corresponding to the first section 761.

For example, the battery diagnosis device 100 may identify the first capacity loss (e.g., 0.025 mAh) by multiplying the first capacity change by the second capacity loss.

The battery diagnosis device 100 according to an embodiment may identify the LLI using the first capacity change and the first capacity loss.

For example, the battery diagnosis device 100 may identify the difference between the first capacity change (e.g., 1.07 Ah) and the first capacity loss (e.g., 0.025 Ah) as the LLI (e.g., 1.045 Ah).

For example, since the LLI occurs in the first section 761 of the first section 761 and the second section 762, the battery diagnosis device 100 may identify the LLI corresponding to the first section 761 as the LLI of the entire battery cell.

In an embodiment, the battery diagnosis device 100 may identify the reference capacity (e.g., 35.15 Ah) of the battery cell from the reference voltage profile. The reference capacity may indicate the total capacity of the battery cell in the BOL state.

For example, the battery diagnosis device 100 may identify the reference capacity (e.g., 35.15 Ah) of the battery cell in the BOL state from the cell capacity value 870 of the reference capacity data 810.

In an embodiment, the battery diagnosis device 100 may identify the LLI rate (e.g., about 2.97%), which represents the ratio of the LLI to the reference capacity of the battery cell.

In an embodiment, the battery diagnosis device 100 may identify the first capacity loss rate (e.g., the LMFP capacity loss rate 860 of FIG. 8) corresponding to the LMFP material using the first capacity loss (e.g., 0.025 Ah) and the second capacity loss (e.g., 1.07 Ah).

For example, the battery diagnosis device 100 may identify the first capacity loss rate using the sum of the first capacity loss and the second capacity loss.

For example, the first capacity loss rate may be expressed as a ratio (e.g., approximately 1.78%) of the sum of the first capacity loss and the second capacity loss to the reference capacity (e.g., 35.15 Ah) of the reference capacity data 810. The battery diagnosis device 100 may identify the first capacity loss rate (e.g., approximately 1.78%) corresponding to LMFP using the sum of the first capacity loss and the second capacity loss for the cell capacity value 870 (e.g., 35.15 Ah) of the reference capacity data 810. The first capacity loss rate may indicate a capacity loss rate of the LMFP.

The battery diagnosis device 100 according to an embodiment may identify the first capacity loss and the LLI using the first section 761 (and the first reference section 711). The battery diagnosis device 100 may identify the second capacity loss and the second capacity loss rate corresponding to the NCM using the second section 362 (and the second reference section 312).

In an embodiment, the battery diagnosis device 100 may identify the degree of degradation of the battery cell using the LLI rate and the LAMc rate. For example, the battery diagnosis device 100 may identify the sum of the LLI rate and the LAMc rate as the degradation degree of the battery cell (e.g., approximately 5.06%). However, it is not limited to thereto. For example, the battery diagnosis device 100 may acquire the degree of degradation of the battery cell using other data distinct from the voltage profile 751.

In an embodiment, the battery diagnosis device 100 may calculate the degree of degradation of the battery cell using the cell capacity value 870. For example, the battery diagnosis device 100 may calculate the degree of degradation of the battery cell using the first reference capacity (e.g., 35.15 Ah) indicating the cell capacity value 870 of the reference capacity data 810 and the second reference capacity (e.g., 33.37 Ah) indicating the cell capacity value 870 of the capacity data 820.

The battery diagnosis device 100 according to an embodiment may identify the second capacity loss rate using the the degree of degradation of the battery cell, the LLI rate of the battery cell, and the first capacity loss rate.

For example, the battery diagnosis device 100 may identify a sum (e.g., about 4.75%) of the LLI rate (e.g., approximately 2.97%) and the first capacity loss rate (e.g., approximately 1.78%). The battery diagnosis device 100 may identify a difference between the degree of degradation of the battery cell (e.g., approximately 5.06%) and the sum as the second capacity loss rate (e.g., approximately 0.31%). The second capacity loss rate may indicate the capacity loss rate of the NCM.

The battery diagnosis device 100 according to an embodiment may identify the LAMc rate of the battery cell using the first capacity loss rate corresponding to the LMFP and the second capacity loss rate corresponding to the NCM.

The battery diagnosis device 100 according to an embodiment may change the upper limit charging voltage of the battery cell when an LLI rate exceeding a designated value is identified. For example, the upper limit charging voltage may indicate the maximum voltage of the voltage of a battery cell that can be charged. For example, when the battery diagnosis device 100 identifies the LLI rate exceeding a designated value, the battery diagnosis device 100 may adjust the charging speed for charging the battery cell.

The battery diagnosis device 100 according to an embodiment as described above may identify at least one peak value (e.g., the first value 760) indicating the phase transition of the LMFP material and the NCM material using the voltage profile. The battery diagnosis device 100 may divide the voltage profile into the first section 761 and the second section 762 using at least one peak value. The battery diagnosis device 100 may identify the first capacity loss of the LMFP corresponding to the first section and the LLI for the entire battery cell using the first section 761. The battery diagnosis device 100 may identify the second capacity loss of the LMFP corresponding to the second section using the second section 762. For example, the battery diagnosis device 100 may identify the capacity loss rate of the NCM using the LLI, the first capacity loss, and the second capacity loss. The battery diagnosis device 100 may identify the degree of degradation of each of one or more materials using the voltage profile 751 for the battery cell containing one or more materials. The battery diagnosis device 100 may improve the accuracy of diagnosis for the battery cell by identifying the degree of degradation of each of one or more materials.

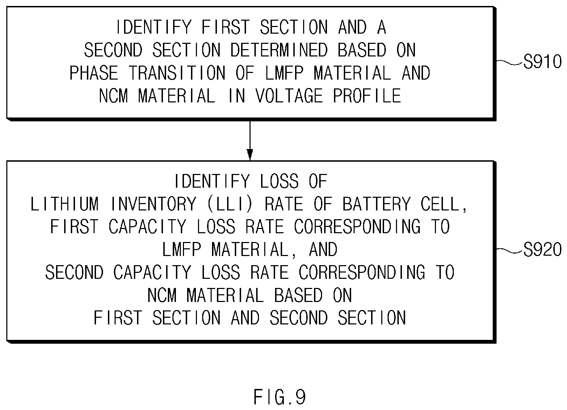

FIG. 9 illustrates an example of a flowchart showing operations performed by a battery diagnosis device according to an embodiment disclosed in this document. In the following, it is assumed that the battery diagnosis device 100 of FIG. 1b performs the process of FIG. 9. In addition, the operations described as being performed by the device may be understood to be controlled by the processor 110 of the battery diagnosis device 100. Each of the operations in FIG. 9 may be performed sequentially, but they are not necessarily performed sequentially. For example, the order of each of the operations may be changed, and at least two operations may be performed in parallel. In addition, the operation of the battery diagnosis device 100 may be performed by a battery management system (BMS) in the vehicle, as well as by various devices such as a server, cloud, charger, or charger/discharger.

In operation S910, the battery diagnosis device 100 according to an embodiment may identify a first section and a second section determined based on a phase transition of an LMFP material and an NCM material in a voltage profile.

For example, the battery diagnosis device may identify a first value and a second value corresponding to the LMFP material based on the voltage profile. For example, the battery diagnosis device may identify a third value corresponding to the NCM material and included between the first value and the second value. For example, the battery diagnosis device 100 may divide a capacity area of a battery cell into a first section containing an initial value of the voltage profile and a second section containing a second value thereof. For example, a third value may be included in the second section.

In operation S920, the battery diagnosis device 100 may according to an embodiment may identify an LLI rate of the battery cell, a first capacity loss rate corresponding to the LMFP material, and a second capacity loss rate corresponding to the NCM material based on the first section and the second section.

For example, the battery diagnosis device 100 may identify the LLI rate and the LAMc rate of the battery cell using a reference voltage profile acquired from the battery cell in a BOL state (e.g., the reference voltage profile 701 of FIG. 7) and the voltage profile acquired from a battery cell in a MOL state (e.g., the voltage profile 751 of FIG. 7).

For example, the LAMc rate may include a first capacity loss rate corresponding to the LMFP material and a second capacity loss rate corresponding to the NCM material.

For example, the battery diagnosis device 100 may identify the LLI rate and the first capacity loss of the LMFP material corresponding to the first section using the first section. For example, the battery diagnosis device may identify the second capacity loss of the LMFP corresponding to the second section using the second section.

For example, the battery diagnosis device may identify a first capacity loss rate indicating the capacity loss of the entire LMFP material using a sum of the first capacity loss and the second capacity loss.

For example, the battery diagnosis device may identify a second capacity loss rate indicating a capacity loss of the NCM material using the LLI rate and the first capacity loss rate of the battery cell. The battery diagnosis device 100 may identify the degree of degradation of the entire battery cell using the first capacity loss rate, the second capacity loss rate, and the LLI rate. However, it is not limited thereto.

For example, the battery diagnosis device may lower the upper limit charging voltage of the battery cell when the LLI rate of the battery cell exceeds a designated value.

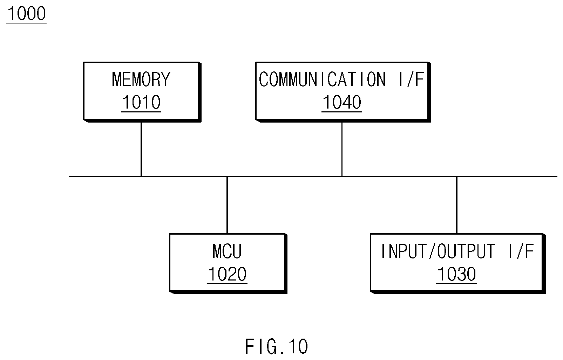

FIG. 10 illustrates a computing system executing a battery diagnosis method according to an embodiment disclosed in this document.

Referring to FIG. 10, a computing system 1100 according to an embodiment disclosed in this document may include an MCU 1010, a memory 1020, an input/output I/F 1030, and a communication I/F 1040.

The MCU 1010 may be a processor that executes various programs stored in the memory 1020 (e.g., an SOH calculation program, a cell balancing target determination program, etc.), processes various data including the state of charge (SOC), state of health (SOH), etc. of a plurality of battery cells through these programs, and performs the functions of the battery diagnosis device 100 described with reference to FIGS. 2 to 6. The MCU 1010 may be, but is not limited to, a BMS, a separate PC, or the cloud.

The memory 1020 may store various programs related to calculating the SOH of battery cells and determining the target for cell balancing. Furthermore, the memory 1020 may store various data, such as SOC data and SOH data for each battery cell.

A plurality of such memories 1020 may be provided as needed. The memory 1020 may be a volatile memory or a nonvolatile memory. The memory 1020 used as the volatile memory may be RAM, DRAM, SRAM, etc. The memory 1020 used as the nonvolatile memory may be ROM, PROM, EAROM, EPROM, EEPROM, flash memory, etc. The examples of the memories 1020 listed above are only examples and are not limited to these examples.

The input/output I/F 1030 may provide an interface that allows data to be transmitted and received by connecting an input device (not shown) such as a keyboard, mouse, or touch panel and an output device (not shown) such as a display with the MCU 1010.

The communication I/F 1040 is a configuration that can transmit and receive various data with the server, and may be various devices that can support wired or wireless communication. For example, a program or various data for calculating the SOH of a battery cell or determining a balancing target may be transmitted to and received from a separately provided external server through the communication I/F 1040.

In this way, the battery diagnosis method according to an embodiment disclosed in this document may be recorded in the memory 1020 and executed by the MCU 1010.

In the above, even though all the components constituting the embodiments disclosed in this document have been described as being combined as one or operating in combination, the embodiments disclosed in this document are not necessarily limited to such embodiments. That is, within the scope of the purpose of the embodiments disclosed in this document, all of the components may be selectively combined and operated in one or more combinations.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above description is merely an example of the technical idea disclosed in this document, and those skilled in the art to which the embodiments disclosed in this document pertain may make various modifications and variations without departing from the essential characteristics of the embodiments disclosed in this document. Accordingly, the embodiments disclosed in this document are intended to describe rather than limit the technical ideas of the embodiments disclosed in this document, and the scope of the technical ideas disclosed in this document is not limited by these embodiments. The scope of protection of the technical ideas disclosed in this document should be interpreted by the scope of the claims below, and all technical ideas within the equivalent scope should be interpreted as being included in the scope of rights of this document.

## Claims

1. A battery diagnosis device comprising:
a memory configured to store a voltage profile that represents a voltage change with respect to a capacity change of a battery cell containing an electrode based on a lithium manganese iron phosphate (LMFP) material and a nickel, cobalt, manganese (NCM) material; and
at least one processor,
wherein the at least one processor is configured to:
identify a first section and a second section determined based on a phase transition of the LMFP material and the NCM material in the voltage profile; and
identify a loss of lithium inventory (LLI) rate of the battery cell, a first capacity loss rate corresponding to the LMFP material, and a second capacity loss rate corresponding to the NCM material, based on the first section and the second section.

2. The battery diagnosis device of claim 1, wherein the at least one processor is configured to:
identify a first value and a second value corresponding to the LMFP material based on the voltage profile;
identify a third value corresponding to the NCM material and included between the first value and the second value; and
identify, based on the first value, a capacity area of the battery cell as the first section including the initial value of the voltage profile and the second section including the second value.

3. The battery diagnosis device of claim 1, wherein the at least one processor is configured to identify a loss of cathode active material (LAMc) rate of the battery cell using the first capacity loss rate and the second capacity loss rate.

4. The battery diagnosis device of claim 1, wherein the at least one processor is configured to identify the second capacity loss rate using the degree of degradation of the battery cell, the LLI rate of the battery cell, and the first capacity loss rate.

5. The battery diagnosis device of claim 1, wherein the at least one processor is configured to:
acquire a reference voltage profile representing a voltage change with respect to a capacity change of the battery cell in a BOL state;
identify a first capacity change corresponding to the first section using the reference voltage profile and the voltage profile; and
identify the LLI rate and a first capacity loss corresponding to the first section, based on the first capacity change.

6. The battery diagnosis device of claim 5, wherein the at least one processor is configured to identify a second capacity loss corresponding to the second section based on a second capacity change corresponding to the second section identified using the reference voltage profile and the voltage profile.

7. The battery diagnosis device of claim 6, wherein the at least one processor is configured to identify the first capacity loss rate using the first capacity loss and the second capacity loss.

8. The battery diagnosis device of claim 6, wherein the at least one processor is configured to identify the first capacity loss based on the second capacity loss and the first capacity change.

9. The battery diagnosis device of claim 1, wherein the at least one processor is configured to change an upper limit charging voltage of the battery cell based on identifying the LLI rate exceeding a designated value.

10. A battery diagnosis method comprising:
an operation of identifying a first section and a second section determined based on a phase transition of a lithium manganese iron phosphate (LMFP) material and a nickel, cobalt, manganese (NCM) material in a voltage profile that represents a voltage change with respect to a capacity change of a battery cell containing an electrode based on the LMFP material and the NCM material; and
an operation of identifying a loss of lithium inventory (LLI) rate of the battery cell, a first capacity loss rate corresponding to the LMFP material, and a second capacity loss rate corresponding to the NCM material, based on the first section and the second section.

11. The battery diagnosis method of claim 10, wherein the operation of identifying the first section and the second section includes:
an operation of identifying a first value and a second value corresponding to the LMFP material based on the voltage profile;
an operation of identifying a third value corresponding to the NCM material and included between the first value and the second value; and
an operation of identifying, based on the first value, a capacity area of the battery cell as the first section including the initial value of the voltage profile and the second section including the second value.

12. The battery diagnosis method of claim 10, wherein the operation of identifying the LLI rate of the battery cell, the first capacity loss rate, and the second capacity loss rate includes an operation of identifying a loss of cathode active material (LAMc) rate of the battery cell using the first capacity loss rate and the second capacity loss rate.

13. The battery diagnosis method of claim 10, wherein the operation of identifying the LLI rate of the battery cell, the first capacity loss rate, and the second capacity loss rate includes an operation of identifying the second capacity loss rate using the degree of degradation of the battery cell, the LLI rate of the battery cell, and the first capacity loss rate.

14. The battery diagnosis method of claim 10, wherein the operation of identifying the LLI rate of the battery cell, the first capacity loss rate, and the second capacity loss rate includes:
an operation of acquiring a reference voltage profile representing a voltage change with respect to a capacity change of the battery cell in a BOL state;
an operation of identifying a first capacity change corresponding to the first section using the reference voltage profile and the voltage profile; and
an operation of identifying the LLI rate and a first capacity loss corresponding to the first section, based on the first capacity change.

15. The battery diagnosis method of claim 14, wherein the operation of identifying the LLI rate of the battery cell, the first capacity loss rate, and the second capacity loss rate further includes an operation of identifying a second capacity loss corresponding to the second section based on a second capacity change corresponding to the second section identified using the reference voltage profile and the voltage profile.
